# EUROPEAN PATENT APPLICATION

(11) **EP 4 640 776 A1**
(43) Date of publication of application: **29.10.2025**
(21) Application number: 23952026.5
(22) Date of filing: 09.11.2023
(51) Int. Cl.: C09D 175/14, C08G 18/28, G11C 13/02, G03H 1/02, G11B 7/245

(54) **COMPOSITION FOR HOLOGRAPHIC RECORDING MEDIUM, AND HOLOGRAPHIC RECORDING MEDIUM**

(30) Priority: 14.09.2023 CN 202311187537
(71) Applicant: Nanchang Virtual Reality Research Institute Co., Ltd., Nanchang, Jiangxi 330013 (CN)
(72) Inventor: LI, Yuan, Nanchang, Jiangxi 330013 (CN); NI, Mingli, Nanchang, Jiangxi 330013 (CN)
(74) Representative: Metida
(86) International application number: PCT/CN2023/130835
(87) International publication number: WO 2025/055101

(57) **Abstract**

This application relates to a composition for a holographic recording medium and a holographic recording medium using the composition for a holographic recording medium. In this application, a substrate film-forming substance contained in the composition for a holographic recording medium is structurally designed, and a refractive index of a substrate is reduced to enhance an overall refractive index difference, so that a high-performance VHG is prepared.

## Description

### TECHNICAL FIELD

This application relates to the field of holographic technology, and specifically, to a composition for a holographic recording medium and a holographic recording medium using the composition for a holographic recording medium.

### BACKGROUND

Holographic technology refers to an optical information technology that utilizes the principle of optical coherence to record the amplitude, phase, and other optical properties of light waves, and is widely used in fields such as holographic anti-counterfeiting and data storage. In this process, a holographic recording medium, as a carrier for holographic recording, is particularly critical, which primarily converts object information into structural differences between exposed areas and unexposed areas through a refractive index modulation difference of a material under photopolymerization reactions, and restores stored information through the principle of diffraction imaging. Therefore, an ideal holographic recording material should have a high refractive index modulation, a wide spectral response range, excellent photosensitivity, low haze, good stability, excellent processability, and inexpensive raw materials.

Currently, typical holographic recording media mainly include silver halide emulsions, dichromated gelatin, photodegradable polymers, photoconductive thermoplastic materials, photoisomerizable materials, photorefractive materials (including liquid crystals), metasurface materials, and photopolymers. Among them, silver halide emulsions have complex post-processing procedures and are prone to generating a large amount of waste liquid, polluting the environment; dichromated gelatin, photodegradable polymers, photoconductive thermoplastic materials, and photoisomerizable materials have the problems of low photosensitivity and refractive index modulation; photorefractive materials typically require an additional external electric field, resulting in complex equipment and poor safety; and metasurface materials have the problems of difficult construction and complex processes. These media are all unable to prepare high-performance volume holographic gratings (VHG). In contrast, photopolymers have advantages such as high photosensitivity, high resolution, and good transparency, also have excellent manufacturability, and gradually become the most promising recording medium in the field of volume holographic recording devices.

Typically, photopolymer formulations mainly include a photoinitiator system, a film-forming resin, a recording monomer, and other additives. The absorption characteristics of the photoinitiator system and the quantum yield of free radical generation determine the speed of the photopolymerization reaction; the film-forming resin serves as a substrate, providing mechanical support for the holographic recording medium on one hand and forming a refractive index difference with the recording monomer on the other hand; the recording monomer provides a high refractive index; other additives, such as toughening agents and leveling agents, have functions such as aiding film formation or suppressing shrinkage. To prepare high-performance VHGs, recording monomers with higher refractive indices are typically required, but this poses the problem that high-refractive-index monomers have limited solubility in the substrate, resulting in limited improvement in overall performance.

In view of this, in this application, from a perspective of the refractive index difference between the substrate and the recording monomer, the substrate is structurally designed, and the refractive index of the substrate is reduced to enhance an overall refractive index difference, so that a high-performance VHG is prepared.

### SUMMARY

An objective of this application is to provide a composition for a holographic recording medium and a holographic recording medium using the composition for a holographic recording medium, to address at least some of the above technical problems.

To achieve the above objective, a first aspect of this application provides a composition for a holographic recording medium. The composition for a holographic recording medium includes the following components: a substrate film-forming substance, an active monomer, a photoinitiator, and a plasticizer. In one embodiment of this application, the substrate film-forming substance is a compound having a group selected from urethane, amide, urea, and epoxy groups, or any combination thereof. In an example embodiment of this application, the substrate film-forming substance is a compound having two or more methyl carbamate structures. Furthermore, to increase a refractive index difference between the substrate film-forming substance and a recording monomer, a special structural design of the substrate film-forming substance is required. In this application, a refractive index of the substrate is adjusted by introducing the fluorine element, and an amount of the fluorine element and a molecular weight of the substrate are controlled. The substrate film-forming substance has a structure of the following general formula: 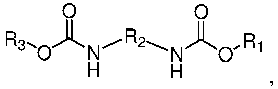 where R₂ is a C₁-C₁₀ carbon chain, and the carbon chain may be linear, cyclic, branched, or heterocyclic; R₁ and R₃ are independently a C₁-C₂₅ carbon chain, and at least one of R₁ and R₃ is an organic carbon chain containing a fluorine atom, preferably a polyfluoro-substituted primary carbon chain; and a mass fraction of the fluorine element is 5%-40%, preferably 10%-30%. The substrate film-forming substance may be synthesized through reaction of isocyanate with polyol/fluorine-modified polyol. It should be noted that the functionality of the selected isocyanate is required to be greater than that of the selected polyol, and an excessive amount of isocyanate is required.

In one embodiment of this application, the active monomer is a C₄-C₂₀ carbon chain having one or more acrylate structures. In an example embodiment of this application, the active monomer is an acrylate substance having an allophanate or carbamate structure. In an example embodiment of this application, to increase a refractive index difference between the active monomer and the substrate film-forming substance, a refractive index of the active monomer is greater than or equal to 1.5.

The photoinitiator, as a sensitizing substance at a specific wavelength, has a significant impact on the photosensitivity of a material in holographic technology and is constrained by its absorption at specific wavelengths. In one embodiment of this application, the photoinitiator is a known compound commercially available on the market. With a light source having a wavelength of 520 nm as an example, the selected photoinitiator may be a combination of a substance such as rose bengal or rhodamine with N-aminoglycine or ethylenediamine, or a combination of a boron-containing quaternary ammonium salt with rose bengal.

To facilitate subsequent processing, a small molecular substance with a high boiling point may also be introduced as a plasticizer in this application. In an example embodiment of this application, the plasticizer is a plasticizer with a boiling point greater than 200 degrees Celsius. In an example embodiment of this application, the plasticizer is dioctyl phthalate (DOP) or dibutyl phthalate (DBP). Without wishing to be bound by theory, it is believed that the composition for a holographic recording medium may further include a catalyst known to persons skilled in the art for substrate reactions.

Furthermore, in another aspect of this application, there are requirements for percentages of the components in the composition for a holographic recording medium. In an example embodiment of this application, based on a total weight of the composition for a holographic recording medium, a percentage of the substrate film-forming substance is 15%-60%, preferably 30%-50%; a percentage of the active monomer is 20%-50%, preferably 35%-40%; a percentage of the photoinitiator and co-initiator is 0.01%-1%, preferably 0.1%-0.3%; and a percentage of the plasticizer is 2%-20%, preferably 2%-8%.

This application further relates to a holographic recording medium prepared using the composition for a holographic recording medium of this application.

This application has the following beneficial effects.

**In** this application, from a perspective of the refractive index difference between the substrate and the recording monomer, the substrate is structurally designed, which can significantly improve the refractive index modulation and is relatively easy to operate; the significance of improving the refractive index modulation lies in significantly enhancing resolution and clarity for optical waveguide components, improving user comfort. The refractive index of the substrate is reduced to enhance an overall refractive index difference, so that a high-performance VHG is prepared. Through fluorination grafting modification on the substrate film-forming substance, it is found that the refractive index of the modified substrate film-forming substance is significantly reduced compared to an unmodified substrate film-forming substance, and there is a certain effect on the diffraction efficiency and refractive index modulation of the prepared holographic recording medium. The inventors have also found that the fluorination modification on the substrate film-forming substance and the number of fluorine atoms are not simply linearly correlated; only under specified ranges of fluorination modification conditions, the prepared holographic recording medium can achieve ideal effects in both diffraction efficiency and refractive index modulation.

### DESCRIPTION OF EMBODIMENTS

To make persons skilled in the art understand the technical solutions in this application better, the following clearly and completely describes the technical solutions in the embodiments of this application. Apparently, the described embodiments are merely some but not all of the embodiments of this application. Based on the embodiments in this application, all other embodiments obtained by persons of ordinary skill in the art without creative efforts shall fall within the protection scope of this application.

Example 1: In a red-light-protected environment, 30%-35% polyether diol (with a molecular weight of 2000), 40% acrylate active monomer, 0.1% rose bengal, and 0.3% N-phenylglycine were pre-mixed first. Then, a plasticizer DOP was added and mixed well. Then, 8%-12% triisocyanate monomer and 0.1% organotin were added and mixed again, and clear photosensitive liquid was obtained. Then, 5%-10% modified compounds with different amounts of fluorine (undecafluoro-n-hexane-1-ol) were added to modify a substrate. Then, under red light protection, a specified amount of the photosensitive liquid was drawn and siphoned to form a film in a glass box with a specified thickness (with a box thickness of 10 µm). Ultimately, after siphoning was completed, the glass box was subjected to light protection treatment using tin foil, placed in an oven, and dried at 72°C for 3 h; and a holographic recording medium was obtained.

Example 2: In a red-light-protected environment, 30%-35% polyether diol (with a molecular weight of 2000), 40% acrylate active monomer, 0.1% rose bengal, and 0.3% N-phenylglycine were pre-mixed first. Then, a plasticizer DOP was added and mixed well. Then, 8%-12% triisocyanate monomer and 0.1% organotin were added and mixed again, and clear photosensitive liquid was obtained. Then, 5%-10% modified compounds with different amounts of fluorine (hexafluorobutanol) were added to modify a substrate. Then, under red light protection, a specified amount of the photosensitive liquid was drawn and siphoned to form a film in a glass box with a specified thickness (with a box thickness of 10 µm). Ultimately, after siphoning was completed, the glass box was subjected to light protection treatment using tin foil, placed in an oven, and dried at 72°C for 3 h; and a holographic recording medium was obtained.

Example 3: In a red-light-protected environment, 30%-35% polyether diol (with a molecular weight of 2000), 40% acrylate active monomer, 0.1% rose bengal, and 0.3% N-phenylglycine were pre-mixed first. Then, a plasticizer DOP was added and mixed well. Then, 8%-12% triisocyanate monomer and 0.1% organotin were added and mixed again, and clear photosensitive liquid was obtained. Then, 5%-10% modified compounds with different amounts of fluorine (2,2,3,3,4,4,5,5,6,6,7,7,8,8,8-pentadecafluorooctan-1-ol) were added to modify a substrate. Then, under red light protection, a specified amount of the photosensitive liquid was drawn and siphoned to form a film in a glass box with a specified thickness (with a box thickness of 10 µm). Ultimately, after siphoning was completed, the glass box was subjected to light protection treatment using tin foil, placed in an oven, and dried at 72°C for 3 h; and a holographic recording medium was obtained.

Comparative Example 1: In a red-light-protected environment, 35%-45% polyether diol (with a molecular weight of 2000), 40% acrylate active monomer, 0.1% rose bengal, and 0.3% N-phenylglycine were pre-mixed first. Then, a plasticizer DOP was added and mixed well. Then, 5%-10% triisocyanate monomer and 0.1% organotin were added and mixed again, and clear photosensitive liquid was obtained. Then, under red light protection, a specified amount of the photosensitive liquid was drawn and siphoned to form a film in a glass box with a specified thickness (with a box thickness of 10 µm). Ultimately, after siphoning was completed, the glass box was subjected to light protection using tin foil, placed in an oven, and dried at 72°C for 3 h; and a holographic recording medium was obtained.

The diffraction efficiency was tested using an ultraviolet spectrophotometer; and the refractive index was tested using an Abbe refractometer.

### Test results

**Table 1: Test results of Examples 1 to 3 and Comparative Example**

| No. | Refractive index of substrate film-forming substance | Diffraction efficiency | Refractive index modulation Δn | Remarks |
|---|---|---|---|---|
| Comparative Example 1 | 1.45 | 50% | 0.0149 | Substrate without fluorine modification |
| Example 1 | 1.39 | 75% | 0.0225 | Substrate with undecafluoro modification |
| Example 2 | 1.42 | 63% | 0.0183 | Substrate with hexafluoro modification |
| Example 3 | 1.37 | 55% | 0.0162 | Substrate with pentadecafluoro modification |

From Table 1, it can be seen that in the holographic recording media in Examples 1 to 3, the substrate film-forming substances subjected to fluorination grafting modification each have a significantly reduced refractive index compared to the unmodified substrate film-forming substance, and there is a certain effect on both the diffraction efficiency and refractive index modulation of the prepared holographic recording medium. The reason is that reducing the refractive index of the substrate can effectively increase the refractive index difference between the substrate and the active monomer. In addition, from the comparison of Examples 1 to 3, it can be found that the fluorination modification on the substrate film-forming substance and the number of fluorine atoms are not simply linearly correlated, because as the number of fluorine atoms grafted onto the substrate film-forming substance increases to a specified value, the compatibility between the substrate film-forming substance and the polymerization product of the active monomer is reduced, causing phase separation of the two phases, thereby increasing the haze of the holographic recording medium and affecting the diffraction efficiency and refractive index modulation of the medium.

In conclusion, it should be noted that the above embodiments are merely intended for describing the technical solutions of this application but not for limiting this application. Although this application is described in detail with reference to the foregoing embodiments, persons of ordinary skill in the art should understand that they may still make modifications to the technical solutions described in the foregoing embodiments or make equivalent replacements to some or all technical features thereof. These modifications or substitutions do not cause the essence of the corresponding technical solutions to depart from the scope of the technical solutions of the embodiments of this application.

## Claims

1. A composition for a holographic recording medium, comprising a substrate film-forming substance, wherein the substrate film-forming substance has a structure of the following general formula: 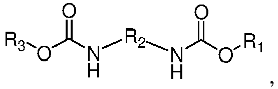 wherein R₂ is a C₁-C₁₀ carbon chain, and the carbon chain is linear, cyclic, branched, or heterocyclic; and R₁ and R₃ are independently a C₁-C₂₅ carbon chain, and at least one of R₁ and R₃ is an organic carbon chain containing a fluorine atom.

2. The composition for a holographic recording medium according to claim 1, wherein at least one of R₁ and R₃ is a polyfluoro-substituted primary carbon chain.

3. The composition for a holographic recording medium according to claim 1 or 2, wherein a mass fraction of the fluorine element in the substrate film-forming substance is 5% to 40%.

4. The composition for a holographic recording medium according to claim 1 or 2, wherein the substrate film-forming substance is prepared through reaction of isocyanate with polyol or fluorine-modified polyol.

5. The composition for a holographic recording medium according to claim 1, further comprising:
an active monomer;
a photoinitiator; and
a plasticizer.

6. The composition for a holographic recording medium according to claim 5, wherein the active monomer is a C₄-C₂₀ carbon chain having one or more acrylate structures; and/or
the photoinitiator is a combination of rose bengal or rhodamine with N-aminoglycine or ethylenediamine, or a combination of a boron-containing quaternary ammonium salt with rose bengal; and/or
the plasticizer is a plasticizer with a boiling point greater than 200 degrees Celsius.

7. The composition for a holographic recording medium according to claim 5 or 6, wherein the active monomer is an acrylate substance having an allophanate or carbamate structure; and/or
the plasticizer is dioctyl phthalate or dibutyl phthalate.

8. The composition for a holographic recording medium according to claim 5 or 6, wherein a refractive index of the active monomer is greater than or equal to 1.5.

9. The composition for a holographic recording medium according to claim 5 or 6, wherein based on a total weight of the composition for a holographic recording medium, a percentage of the substrate film-forming substance is 15%-60%, a percentage of the active monomer is 20%-50%, a percentage of the photoinitiator is 0.01 %-1 %, and a percentage of the plasticizer is 2%-20%.

10. A holographic recording medium, prepared using the composition for a holographic recording medium according to any one of claims 1 to 9.
